(19) Europäisches Patentamt
European Patent Office
Office européen des brevets

(11) **EP 1 605 560 B1**

(12) **EUROPÄISCHE PATENTSCHRIFT**

(45) Veröffentlichungstag und Bekanntmachung des Hinweises auf die Patenterteilung:
**03.08.2016 Patentblatt 2016/31**

(51) Int Cl.:
*H01S 5/068* (2006.01)     *H01S 5/024* (2006.01)
*H01S 5/06* (2006.01)

(21) Anmeldenummer: **05002961.0**

(22) Anmeldetag: **11.02.2005**

(54) **Vorrichtung mit einem strahlungsemittierenden Halbleiterbauelement und Verfahren zur Temperaturstabilisierung eines strahlungsemittierenden Halbleiterbauelements**

Lightemitting semiconductor device and method for temperature stabilisation

Emetteur de lumière à semiconducteur et méthode de stabilisation de la temperature

(84) Benannte Vertragsstaaten:
**DE**

(30) Priorität: **25.02.2004 DE 102004009588**
            **28.01.2005 DE 102005004145**

(43) Veröffentlichungstag der Anmeldung:
**14.12.2005 Patentblatt 2005/50**

(73) Patentinhaber: **OSRAM Opto Semiconductors GmbH**
**93055 Regensburg (DE)**

(72) Erfinder:
• **Morgott, Stefan**
**93049 Regensburg (DE)**

• **Steegmüller, Ulrich**
**93059 Regensburg (DE)**
• **Friepes, Klaus**
**93055 Regensburg (DE)**

(74) Vertreter: **Epping - Hermann - Fischer Patentanwaltsgesellschaft mbH**
**Schloßschmidstraße 5**
**80639 München (DE)**

(56) Entgegenhaltungen:
**EP-A- 1 369 722**     **WO-A-00/41349**
**DE-A1- 19 755 457**

EP 1 605 560 B1

**Beschreibung**

Die Erfindung betrifft eine Vorrichtung mit einem strahlungsemittierenden Halbleiterbauelement und ein Verfahren zur Temperaturstabilisierung eines strahlungsemittierenden Halbleiterbauelements.

Die Peakwellenlänge der von einer Laserdiode einer derartigen Vorrichtung emittierten Strahlung wird bekanntlich von der Betriebstemperatur des Halbleiterbauelements beeinflusst, die von der Umgebungstemperatur des Halbleiterbauelements abhängt. Änderungen in der Umgebungstemperatur können somit zu Schwankungen der Peakwellenlänge des Halbleiterbauelements führen. Derartige Schwankungen der Peakwellenlänge sind jedoch oftmals unerwünscht. Die Peakwellenlänge eines Laserdiodenbauelements wird deshalb des öfteren durch zusätzliche Maßnahmen stabilisiert. Bei kantenemittierenden Laserdioden beispielsweise kann ein spektraler Filter, etwa ein Bragg-Gitter, wie bei DFB- (Distributed Feedback) oder DBR-Lasern (Distributed Bragg Reflector), zur Wellenlängenstabilisierung in das Bauelement integriert werden. Derartige Laser sind jedoch meist nur für vergleichsweise geringe optische Ausgangsleistungen geeignet. Bei Halbleiterlaser-Bauelementen mit externem Resonator, etwa mit vertikaler Emissionsrichtung (z.B. VECSEL: Vertical External Cavity Surface Emitting Laser) kann zur Wellenlängenstabilisierung ein Beugungsgitter oder eine Bragg-Faser als Filterelement im Resonator angeordnet werden. Hierdurch können resonatorinterne Verluste gezielt so erhöht werden, dass die Peakwellenlänge des Bauelements vergleichsweise stabil ist. Weiterhin kann eine Laserdiode zur Wellenlängenstabilisierung entsprechend gekühlt werden, z. B. über ein Peltier-Element oder Kühlwasser.

Die vorstehenden Maßnahmen zur Wellenlängenstabilisierung sind jedoch vergleichsweise aufwändig und/oder kostenintensiv. Ein spektraler Filter etwa muss bei der Herstellung in eine Laserdiodenstruktur integriert werden, ein Beugungsgitter oder eine Bragg-Faser im Resonator angeordnet und justiert werden. Peltier-Elemente sind weiterhin vergleichsweise kostenintensiv, und Kühlwasserkreisläufe, die gewöhnlich einen hohen Platzbedarf aufweisen, sind neben den hohen Kosten auch vergleichsweise aufwändig zu realisieren.

Aufgabe der vorliegenden Erfindung ist es, eine Vorrichtung mit einem strahlungsemittierenden Halbleiterbauelement anzugeben, dessen Peakwellenlänge vereinfacht stabilisierbar ist. Zudem soll die Vorrichtung kostengünstig verwirklichbar und über einen weiten Umgebungstemperaturbereich zuverlässig mit stabilisierter Peakwellenlänge einsetzbar sein. Weiterhin ist es eine Aufgabe der Erfindung, ein vereinfachtes Verfahren zur Wellenlängenstabilisierung eines strahlungsemittierenden Halbleiterbauelements anzugeben.

Diese Aufgabe wird erfindungsgemäß durch eine Vorrichtung mit den Merkmalen des Patentanspruchs 1 und ein Verfahren nach Patentanspruch 26 gelöst. Vorteilhafte Weiterbildungen sind Gegenstand der abhängigen Patentansprüche.

Eine erfindungsgemäße Vorrichtung umfasst mindestens ein strahlungsemittierendes Halbleiterbauelement, wobei dem Halbleiterbauelement mindestens ein elektrisches Heizelement zugeordnet ist, das zum Heizen des Halbleiterbauelements ausgebildet ist.

Durch Heizen des Halbleiterbauelements mittels des Heizelements kann die Änderung der Betriebstemperatur des Halbleiterbauelements gegenüber der Änderung der Umgebungstemperatur über einen vorgegebenen Umgebungstemperaturbereich, in dem das Halbleiterbauelement zum Betrieb vorgesehen ist, verringert werden. Die Betriebstemperatur des Halbleiterbauelements kann so auf einen Betriebstemperaturbereich stabilisiert werden, der vom vorgegebenen Umgebungstemperaturbereich derart vollständig überdeckt wird, dass der Umgebungstemperaturbereich Temperaturen aufweist, die außerhalb des Betriebstemperaturbereichs des temperaturstabilisierten Halbleiterbauelements liegen. Schwankungen in der Betriebstemperatur des Halbleiterbauelements können so verringert werden, wodurch aufgrund der Temperaturabhängigkeit der Peakwellenlänge einer vom Halbleiterbauelement erzeugten Strahlung die Schwankung der Peakwellenlänge im Betrieb des Halbleiterbauelements über den vorgegebenen Umgebungstemperaturbereich verringert wird.

Auf aufwändige herzustellende und/oder kostenintensive, im Halbleiterbauelement integrierte spektrale Filter oder justageaufwändige externe Filterelemente kann so ebenso wie auf kostenintensive Kühlung vorteilhaft verzichtet werden. Insbesondere kann das elektrische Heizelement als externes, außerhalb des Halbleiterbauelements angeordnetes, Heizelement ausgeführt sein. Ein elektrisches Heizelement erleichtert weiterhin mit Vorteil die Heizungssteuerung, etwa aufgrund einer vereinfachten Montage des Heizelements in der Vorrichtung.

Halbleiterbauelemente für eine derartige Vorrichtung können somit mit Vorteil in einem kostengünstigen Standardprozess gefertigt werden und die Peakwellenlänge kann für gleichartig gefertigte Halbleiterbauelemente individuell über das jeweils zugeordnete Heizelement stabilisiert werden.

Es sei angemerkt, dass im Rahmen der vorliegenden Anmeldung der Begriff Umgebungstemperatur bzw. Umgebungstemperaturbereich teilweise stellvertretend für den Begriff Betriebstemperatur bzw. Betriebstemperaturbereich eines nicht temperaturstabilisierten, insbesondere ungeheizten, Halbleiterbauelements verwendet wird. Die Betriebstemperatur eines nicht temperaturstabilisierten Halbleiterbauelements unterscheidet sich aufgrund der im Betrieb anfallenden Wärme zwar in der Regel von der Umgebungstemperatur, kann jedoch maßgeblich von dieser beeinflusst werden. Die Umgebungstemperatur stellt jedenfalls eine untere Grenze für die Betriebstemperatur eines nicht temperaturstabilisierten Halbleiterbauelements dar, falls die Verlustwärme im Betrieb des Halbleiterbauelements, etwa aufgrund eines Betriebs mit geringer Leistung, vernachlässigbar ist und auf zusätzliche Kühlmaßnahmen verzichtet wird. Bei der Erfindung dagegen kann die Betriebstemperatur des Halbleiterbauelements durch elektrische Heizung des Bauelements über der Umgebungstemperatur gehalten werden, so dass die Umgebungstemperatur keine untere Grenze für die Betriebstemperatur darstellt.

In einem erfindungsgemäßen Verfahren zur Temperaturstabilisierung der Betriebstemperatur eines strahlungsemittierenden Halbleiterbauelements, insbesondere eines Bauelements der Vorrichtung, ist dem Halbleiterbauelement ein elektrisches Heizelement zugeordnet, mittels dem das Halbleiterbauelement beim Unterschreiten eines vorgegebenen Sollwerts der Betriebstemperatur des Halbleiterbauelements geheizt wird. Hierdurch kann, wie bereits oben erwähnt, die Betriebstemperatur des Halbleiterbauelements in einem Betriebstemperaturbereich gehalten werden, der gegenüber dem vorgegebenen Umgebungstemperaturbereich als Betriebstemperaturbereich geschmälert ist.

In einer bevorzugten Ausgestaltung wird beim Überschreiten des vorgegebenen Sollwerts der Betriebstemperatur des Halbleiterbauelements die Heizleistung des Heizelements reduziert oder das Heizelement wird ausgeschaltet. Übermäßiges Heizen des Halbleiterbauelements und die Gefahr einer Schädigung des überheizten Halbleiterbauelements wird so verringert.

In einer weiteren bevorzugten Ausgestaltung ist das Halbleiterbauelement zur Erzeugung von Strahlung einer Peakwellenlänge ausgebildet, die über den vorgegebenen-Umgebungstemperaturbereich, in dem das Halbleiterbauelement zum Betrieb vorgesehen ist, in einem Schwankungsbereich variiert. Der Schwankungsbereich muss nicht notwendigerweise zusammenhängend sein, vielmehr kann auch eine sprunghafte Änderung der Peakwellenlänge auftreten.

Gegenüber dem Schwankungsbereich des unbeheizten Halbleiterbauelements mit einer maßgeblich von der Umgebungstemperatur beeinflussten Betriebstemperatur kann der Schwankungsbereich der Peakwellenlänge des beheizten Halbleiterbauelements geschmälert sein.

Insbesondere kann eine Breite des Schwankungsbereichs der Peakwellenlänge über Heizen des Halbleiterbauelements mittels des Heizelements von einer ersten Breite des ungeheizten Halbleiterbauelements auf eine zweite Breite des geheizten Halbleiterbauelements reduziert werden, wobei die zweite Breite kleiner als die erste Breite ist. Der Schwankungsbereich der ersten Breite überdeckt denjenigen der zweiten Breite vorzugsweise vollständig. Der Schwankungsbereich kann derart geschmälert werden, dass die zweite Breite 60 %, vorzugsweise 55 %, oder weniger der ersten Breite beträgt.

Als Breite wird hierbei der Betrag der Differenz der kleinsten und der größten Peakwellenlänge über den Betriebstemperaturbereich des Halbleiterbauelements angesehen. Die Breite des Schwankungsintervalls des ungeheizten Halbleiterbauelements ist zumindest ungefähr durch die Differenz der maximalen und der minimalen Peakwellenlänge bestimmt, die vom Halbleiterbauelement emittierte Strahlung für eine Betriebstemperatur des Halbleiterbauelements über den gesamten Umgebungstemperaturbereich annimmt. Entsprechendes gilt für die Breite des Schwankungsintervalls des temperaturstabilisierten, geheizten Halbleiterbauelements.

Die Schwankung der Peakwellenlänge des Halbleiterbauelements kann somit insgesamt mittels gezielter Temperaturstabilisierung über das elektrische Heizelement vorteilhaft verringert werden. In der Folge wird die Peakwellenlänge des Halbleiterbauelements stabilisiert.

Bevorzugt ist das Halbleiterbauelement zum Betrieb in einem Umgebungstemperaturbereich, der Temperaturen kleiner und größer 0°C, insbesondere von -40°C bis 85°C, umfasst, vorgesehen. Mittels der elektrischen Heizung kann erreicht werden, dass die Betriebstemperatur des Halbleiterbauelements bei Temperaturen, insbesondere durchweg, im Bereich größer 0°C, insbesondere im Bereich von 20°C bis 85°C, liegt. Ein Betriebstemperaturfenster des Halbleiterbauelements kann von einem ersten Fenster des ungeheizten, etwa einer Breite von 125 K, auf ein zweites Fenster des geheizten Halbleiterbauelements, etwa einer Breite von 65 K, geschmälert sein. Derartige Temperaturen können bei Außenanwendungen des Halbleiterbauelements, etwa in einer Vorrichtung im Fahrzeugbereich, auftreten.

In einer weiteren bevorzugten Ausgestaltung ist dem Halbleiterbauelement ein, vorzugsweise elektrischer, Temperatursensor zur Überwachung der Betriebstemperatur des Halbleiterbauelements zugeordnet. Bevorzugt kann der Betrieb des elektrischen Heizelements mittels des Temperatursensors, etwa mittels eines im Temperatursensor erzeugten oder eines am Temperatursensor ermittelten Signals, gesteuert werden.

Ein NTC-Element mit negativem Temperaturkoeffizienten (Negative Temperature Coefficient), etwa ein NTC-Thermistor (Thermistor: Ein temperaturabhängiger Widerstand), ist als Temperatursensor besonders geeignet.

Über den Temperatursensor wird vorzugsweise die Betriebstemperatur des Halbleiterbauelements ermittelt. Beim Unterschreiten des vorgegebenen Sollwerts kann ein Heizen des Halbleiterbauelements mittels des Heizelements veranlasst werden. Wird der Sollwert überschritten wird zweckmäßigerweise die Heizleistung reduziert oder das Heizelement ausgeschaltet. Liegt die Betriebstemperatur bereits über dem Sollwert, so wird das Heizelement bevorzugt nicht betrieben. Diese Heizungssteuerung kann gegebenenfalls über ein externes Auswerteelement erfolgen, das die mittels des Temperatursensors bestimmte Betriebstemperatur des Halbleiterbauelements überwacht und mit dem Sollwert vergleicht.

In einer weiteren bevorzugten Ausgestaltung ist dem Halbleiterbauelement ein Detektorelement zur Detektion der vom Halbleiterbauelement emittierten Strahlung zugeordnet, das zur Detektion von Strahlung mit Wellenlängen in einem vorgegebenen, vorzugsweise zusammenhängenden, Detektionsbereich ausgebildet ist. Derartige Detektorelemente sind häufig in einer Sensorvorrichtung mit einem Halbleiterbauelement als Sender und dem Detektor als Empfänger vorgesehen, wobei der Detektionsbereich zur Vermeidung unerwünschter Umgebungslichteinflüsse, welche oftmals ein Rauschen des Detektorsignals verursachen, vorzugsweise möglichst schmal ist.

Der Detektionsbereich in einer herkömmlichen derartigen Vorrichtung ist oft so gewählt, dass er den Schwankungsbereich der Peakwellenlänge über den Umgebungstemperaturbereich umfasst, um eine Detektion der Strahlung des ungeheizten Halbleiterbauelements mit einer Betriebstemperatur über im wesentlichen den gesamten Umgebungstemperaturbereich zu sichern. Bei der Erfindung dagegen kann der Detektionsbereich derart ausgebildet sein, dass der Schwankungsbereich der Peakwellenlänge des ungeheizten Halbleiterbauelements Wellenlängen außerhalb des Detektionsbereichs aufweist und der Detektionsbereich den Schwankungsbereich der Peakwellenlänge des temperaturstabilisierten Halbleiterbauelements, vorzugsweise vollständig, überdeckt. Das Detektorelement kann somit in einer Vorrichtung mit einem temperaturstabilisierten Halbleiterbauelement gegenüber einer Vorrichtung mit einem nicht temperaturstabilisierten Halbleiterbauelement mit einem schmalbandigeren Detektionsbereich ausgeführt sein und Umgebungslichteinflüsse auf ein Detektorsignal können vorteilhaft verringert werden. Als Strahlungsdetektoren eignen sich beispielsweise besonders Fotodioden, etwa PIN-oder Lawinen-Fotodioden (APD: Avalanche Photodiode), vorzugsweise auf Si basierend, deren Detektionsbereich durch entsprechende Filter an das Halbleiterbauelement bzw. den Schwankungsbereich der Peakwellenlänge des geheizten Halbleiterbauelements angepasst ist.

In einer weiteren bevorzugten Ausgestaltung ist das Halbleiterbauelement als Halbleiterlaser-Bauelement, insbesondere Hochleistungslaser-Bauelement, ausgeführt. Aufgrund der vergleichsweise schmalbandigen Emissionsspektren von Halbleiterlaser-Bauelementen macht sich die Temperaturabhängigkeit der Peakwellenlänge bei Halbleiterlaser-Bauelementen oft besonders stark bemerkbar. Das Halbleiterlaser-Bauelement kann beispielsweise als kantenemittierende Laserdiode oder als Laserdiodenbarren ausgebildet sein. Ein Laserdiodenbarren umfasst hierbei eine Mehrzahl von Laserdiodenstrukturen (Laserdiodenkanäle), die monolithisch integriert und auf einem gemeinsamen Substrat angeordnet sind. Weiterhin kann das Halbleiterbauelement als oberflächenemittierendes Halbleiterbauelement, insbesondere Halbleiterlaser-Bauelement, ausgeführt sein. Beispielsweise kann das oberflächenemittierende Halbleiterbauelement als vertikal emittierendes Halbleiterlaser-Bauelement mit internem Resonator (VCSEL: Vertical Surface Emitting Laser) oder mit externem Resonator (VECSEL) ausgebildet sein. Bevorzugt ist das Halbleiterlaser-Bauelement zum gepulsten Betrieb, insbesondere in einer Sensorvorrichtung mit einem dem Bauelement zugeordneten Detektorelement, vorgesehen.

In einer weiteren bevorzugten Ausgestaltung ist das Halbleiterbauelement auf einem Träger, etwa einer Leiterplatte, angeordnet. Vorzugsweise ist das Heizelement ebenfalls auf dem Träger angeordnet. Hierdurch wird, insbesondere über eine vergleichsweise nah benachbarte Anordnung des Heizelements und des Halbleiterbauelements, eine effiziente Beheizung des Halbleiterbauelements erleichtert. Weiterhin ist das Heizelement und/oder gegebenenfalls der Temperatursensor, bevorzugt oberflächenmontierbar (SMD: Surface Mountable Device) ausgebildet, wodurch eine Montage des Heizelements auf dem Träger und eine kompakte Ausbildung der Vorrichtung erleichtert werden.

In einer weiteren bevorzugten Ausgestaltung ist das Heizelement als Heizwiderstand ausgeführt. Durch Anlegen einer Spannung an den Heizwiderstand kann über Stromfluss durch den Heizwiderstand dementsprechend Wärme erzeugt und das Halbleiterbauelement beheizt werden.

In einer weiteren bevorzugten Ausgestaltung ist das Heizelement im Träger des Halbleiterbauelements integriert. Der Träger kann somit schon mit integriertem Heizelement bereitgestellt werden, wodurch auf eine zusätzliche Anordnung eines separaten Heizelements auf dem Träger verzichtet werden kann. Bevorzugt weist der Träger hierzu eine Mehrschichtstruktur auf und das Heizelement ist als Heizwiderstandsschicht in der Mehrschichtstruktur integriert. Besonders geeignet ist hierzu eine Mehrschicht-Leiterplatte, die eine, vorzugsweise in eine oder mehrere, etwa meanderförmig verlaufende, Heizwiderstandsbahn(en) strukturierte und/oder Cu enthaltende, Heizwiderstandsschicht aufweiset.

In einer weiteren bevorzugten Ausgestaltung ist das Heizelement zwischen dem Träger und dem Halbleiterbauelement oder das Halbleiterbauelement ist auf dem Heizelement angeordnet. Durch eine derartige Nähe von Heizelement und Halbleiterbauelement wird eine effiziente, flächige Beheizung des Halbleiterbauelements erleichtert.

In einer weiteren bevorzugten Ausgestaltung der Erfindung ist zwischen dem Träger und dem Halbleiterbauelement ein Zwischenträger (Submount) angeordnet. Mittels eines derartigen Zwischenträgers kann die Gefahr einer Abschattung der vom Halbleiterbauelement emittierten Strahlung durch eine Kante des Trägers verringert werden.

In einer vorteilhaften Weiterbildung ist der Zwischenträger als Heizelement ausgebildet oder der Zwischenträger enthält das Heizelement. Hierbei ist das Heizelement vorzugsweise ein Heizwiderstandsbereich, der im Zwischenträger ausgebildet sein kann. Ein derartiger Heizwiderstandsbereich kann mittels Implantation, etwa Protonen-Implantation, in einen Bereich des Zwischenträgers realisiert sein. Vorzugsweise enthält der Zwischenträger hierzu ein Halbleitermaterial, etwa Si. Bevorzugt ist der Heizwiderstandsbereich weiterhin im Zwischenträger oberflächennah an der dem Halbleiterbauelement zugewandten Oberfläche des Zwischenträgers ausgeführt und/oder an dieser Oberfläche elektrisch anschließbar.

In einer weiteren bevorzugten Ausgestaltung ist das Heizelement elektrisch von dem Halbleiterbauelement isoliert. Somit ist eine getrennte elektrische Ansteuerung von Heizelement und Halbleiterbauelement möglich. Insbesondere können das Heizelement und das Halbleiterbauelement mit Vorteil unabhängig voneinander betrieben werden.

In einer weiteren bevorzugten Ausgestaltung ist das Heizelement gesondert thermisch leitend mit dem Halbleiterbauelement verbunden. Die Effizienz der Beheizung kann so erhöht werden. Hierzu kann beispielsweise ein thermischer Verbindungsleiter, etwa Cu enthaltend, vorgesehen sein, der das Halbleiterbauelement und das Heizelement thermisch leitend verbindet.

In einer vorteilhaften Weiterbildung der Erfindung ist der Temperatursensor gesondert thermisch leitend mit dem Halbleiterbauelement verbunden. Aufgrund einer thermisch leitenden Verbindung kann die Temperatur effizienter überwacht werden, da die Gefahr einer Abweichung der mittels des Temperatursensors bestimmten Betriebstemperatur von einer tatsächlichen Betriebstemperatur des Halbleiterbauelements verringert wird. Zur Verbesserung der thermischen Anbindung kann beispielsweise ein weiterer thermischer Verbindungsleiter, etwa Cu enthaltend, vorgesehen sein, der das Halbleiterbauelement und den Temperatursensor thermisch leitend verbindet.

In einer weiteren bevorzugten Ausgestaltung der Erfindung erfolgt die Heizung des Halbleiterbauelements über das Material des Trägers. Insbesondere kann die Wärmezufuhr durch ein elektrisch isolierendes Grundmaterial des Trägers erfolgen. Auf das Ausbilden gesonderter thermischer Verbindungsleiter kann so verzichtet werden.

Weitere Merkmale, Vorteile und Zweckmäßigkeiten der Erfindung ergeben sich aus der Beschreibung der folgenden Ausführungsbeispiele in Verbindung mit den Figuren.

Es zeigen:

Figur 1 in Figur 1A eine schematische Aufsicht auf ein erstes Ausführungsbeispiel einer erfindungsgemäßen Vorrichtung und in Figur 1B eine entsprechende Schnittansicht entlang der Linie A-A aus Figur 1A,

Figur 2 in Figur 2A eine schematische Aufsicht eines zweiten Ausführungsbeispiels einer erfindungsgemäßen Vorrichtung von oben und in Figur 2B eine schematische Aufsicht von unten,

Figur 3 eine schematische Aufsicht auf ein drittes Ausführungsbeispiel einer erfindungsgemäßen Vorrichtung in Figur 3A und eine entsprechende schematische Schnittansicht in Figur 3B,

Figur 4 eine schematische Aufsicht auf ein viertes Ausführungsbeispiel einer erfindungsgemäßen Vorrichtung,

Figur 5 eine schematische Schnittansicht eines fünften Ausführungsbeispiels einer erfindungsgemäßen Vorrichtung in Figur 5A und eine entsprechende schematische Schnittaufsicht eines Schnitts entlang der Linie A-A in Figur 5B,

Figur 6 eine schematische Aufsicht auf ein sechstes Ausführungsbeispiel einer erfindungsgemäßen Vorrichtung

Figur 7 die Temperaturabhängigkeit des Emissionsspektrums eines Halbleiterlaser-Bauelements, etwa gemäß dem Ausführungsbeispiel aus Figur 6, in Abhängigkeit von der elektrischen Heizleistung,

Figur 8 die Temperaturabhängigkeit des Widerstandes einer Heizwiderstandsschicht,

Figur 9 einen Vergleich der Temperaturänderung der Betriebstemperatur eines Halbleiterlaser-Bauelements in Abhängigkeit von der Heizleistung für ein mit verschiedenen Methoden beheiztes Halbleiterlaser-Bauelement,

Figur 10 die Abhängigkeit der optischen Peak-Leistung eines Halbleiterlaser-Bauelements von der Änderung der Betriebstemperatur des Halbleiterlaser-Bauelements,

Figur 11 einen Vergleich der Temperaturänderung $\Delta T$ der Betriebstemperatur des Halbleiterlaser-Bauelements in Abhängigkeit von der Heizleistung für ein mit verschiedenen Methoden beheiztes Halbleiterlaser-Bauelement,

Figur 12 einen Vergleich der Temperaturbestimmung der Betriebstemperatur eines Halbleiterlaser-Bauelement über zwei verschiedene Methoden und

Figur 13 das thermische Einschwingverhalten des Halbleiterlaser-Bauelements für drei Beheizungsvarianten.

Gleiche, gleichartige oder gleichwirkende Elemente sind in den Figuren mit den gleichen Bezugszeichen versehen.

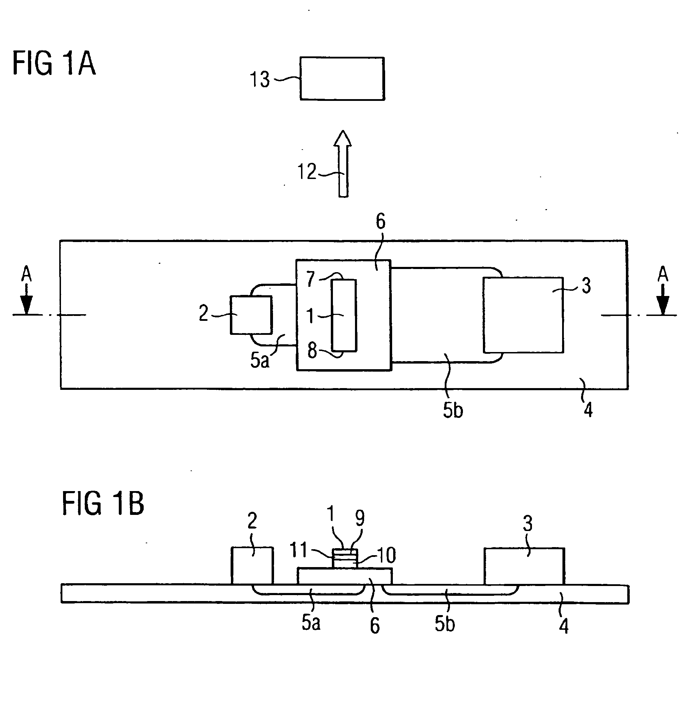

Figur 1 zeigt ein erstes Ausführungsbeispiel einer erfindungsgemäßen Vorrichtung anhand einer schematischen Aufsicht in Figur 1A und einer schematischen Schnittansicht in Figur 1B entlang der Linie A-A.

Einem strahlungsemittierenden Halbleiterbauelement 1 der Vorrichtung ist ein elektrisches Heizelement 2 zugeordnet, das zum Heizen des Halbleiterbauelements ausgebildet ist. Das Heizelement und das Halbleiterbauelement sind mit einem, insbesondere elektrischen, Temperatursensor 3 auf einem, insbesondere gemeinsamen, Träger 4 angeordnet. Zwischen dem Halbleiterbauelement 1 und dem Träger 4 ist ein Zwischenträger 6 angeordnet, der aufgrund der mittels des Zwischenträgers gegenüber dem Träger erhöhten Anordnung des Halbleiterbauelements die Abschattung einer vom Halbleiterbauelement emittierten Strahlung 12 durch den Träger 4 vermindert.

Dem Halbleiterbauelement 1 ist weiterhin ein Detektorelement 13, etwa eine PIN- oder Lawinenfotodiode, zur Detektion einer vom Halbleiterbauelement erzeugten Strahlung 12 zugeordnet. Das Detektorelement kann, anders als dargestellt, ebenfalls auf dem Träger 4 angeordnet sein. Eine kompakte Ausbildung einer derartigen Sensorvorrichtung wird so erleichtert.

Bevorzugt ist zwischen dem Heizelement und dem Halbleiterbauelement und/oder dem Halbleiterbauelement und dem Temperatursensor eine gesonderte thermisch leitende Verbindung ausgebildet. Beispielsweise ist hierzu ein erster thermischer Verbindungsleiter 5a mit dem Heizelement 2 und dem Halbleiterbauelement 1 und ein zweiter Verbindungsleiter 5b mit dem Halbleiterbauelement und dem Temperatursensor thermisch leitend verbunden. Thermisch sind die Verbindungsleiter mit Vorzug nicht unmittelbar leitend verbunden. Beispielsweise enthalten die Verbindungsleiter 5a und 5b ein Metall, etwa Cu.

Weiterhin ist der Träger bevorzugt als Leiterplatte, etwa als PCB (PCB: Printed Circuit Board) ausgeführt. Auf:die Darstellung von Leiterbahnen der Leiterplatte sowie elektrischer Anschlüsse des Heizelements 2, des Halbleiterbauelements 1 und des Temperatursensors 3 wurde der Übersichtlichkeit halber verzichtet. Besonders bevorzugt sind das Halbleiterbauelement, das Heizelement und der Temperatursensor über Leiterbahnen der Leiterplatte, insbesondere elektrisch voneinander getrennt, anschließbar und/oder ansteuerbar. Vorzugsweise sind die thermischen Verbindungsleiter im Träger integriert.

Alternativ kann jedoch auch auf die thermischen Verbindungsleiter verzichtet werden. Die Beheizung des Halbleiterbauelements erfolgt dann vorzugsweise über das Material des Trägers. Insbesondere kann die Wärmezufuhr zum Halbleiterbauelement in diesem Falle durch ein elektrisch isolierendes Grundmaterial, z.B. ein Kunststoffmaterial, des Trägers erfolgen.

Das elektrische Heizelement, das Halbleiterbauelement und/oder der Temperatursensor ist bevorzugt oberflächenmontierbar ausgeführt und kann zum Beispiel auf den Träger gelötet sein. Beispielsweise ist der Temperatursensor als oberflächenmontierbarer NTC-Thermistor und/oder das elektrische Heizelement als oberflächenmontierbarer Heizwiderstand ausgeführt. Das Halbleiterbauelement ist bevorzugt ohne zusätzliches Gehäuse auf dem Träger montiert (Chip on Board).

Eine thermisch leitende Verbindung zwischen dem elektrischen Heizelement 2 und/oder dem Temperatursensor 3 und dem Halbleiterbauelement 1 kann mit Vorteil mittels des Zwischenträgers 6 erzielt werden. Hierzu ist der Zwischenträger zweckmäßigerweise mit einer entsprechend hohen thermischen Leitfähigkeit ausgebildet. Beispielsweise enthält der Zwischenträger ein Halbleitermaterial, etwa Si, oder ein Metall, wie Cu, oder eine Legierung, etwa CuWo. Derartige Materialien können sich neben einer vergleichsweise hohen thermischen Leitfähigkeit auch durch gute Anpassung an den thermischen Ausdehnungskoeffizienten des Halbleiterbauelements auszeichnen, wodurch die Gefahr thermisch induzierter Verspannungen im Halbleiterbauelement verringert wird.

Es sei angemerkt, dass die Verbindungsleiter 5a oder 5b nicht notwendigerweise, wie dargestellt, auf der dem Halbleiterbauelement zugewandten Seite des Trägers angeordnet sein müssen. Ein Verbindungsleiter kann sich auch von der Seite des Trägers, auf der das Halbleiterbauelement angeordnet ist, zu der dem Halbleiterbauelement gegenüberliegenden Seite des Trägers erstrecken. Das Heizelement und/oder der Temperatursensor können so vereinfacht auf der dem Halbleiterbauelement gegenüberliegenden Seite des Trägers angeordnet sein und über einen oder eine Mehrzahl von thermische(n) Verbindungsleiter (n) thermisch leitend mit dem Halbleiterbauelement verbunden sein, wobei die Betriebseffizienz der Vorrichtung trotz der derartigen Anordnung mit Vorteil nicht maßgeblich vermindert wird.

Gegebenenfalls kann eine thermisch leitende Verbindung auch über den Träger, vorzugsweise durch ein elektrisch isolierende Grundmaterial, etwa einen Kunststoff, des Trägers, erfolgen.

Das Halbleiterbauelement 1 weist mit Vorzug eine zur Strahlungserzeugung vorgesehene aktive Zone 9 auf, die beispielsweise in einer auf einem Substrat 10 angeordneten Halbleiterkörper 11 ausgebildet ist. Zweckmäßigerweise ist das Substrat 10 aus einem Epitaxiesubstrat des Halbleiterkörpers 11 gefertigt.

Das Halbleiterbauelement kann beispielsweise als Halbleiterlaser-Bauelement, insbesondere zum gepulsten Betrieb, ausgeführt sein. Bevorzugt ist das Halbleiterlaser-Bauelement als kantenemittierende Laserdiode ausgeführt. Hierbei begrenzen vorzugsweise gegenüberliegende Seitenflächen 7 und 8 (Reflektorflächen) des Halbleiterlaser-Bauelements einen optischen Resonator (z.B. einen Fabry-Perot-Resonator) des Bauelements.

Zur Strahlungserzeugung im infraroten Spektralbereich ist ein GaAs-basierender Halbleiterkörper, insbesondere auf einem GaAs Epitaxiesubstrat gewachsen, besonders geeignet.

Ist das Halbleiterbauelement als Laserdiodenbarren ausgeführt, so ist mit Vorzug eine Mehrzahl von Halbleiterkörpern 11 nebeneinander auf dem gemeinsamen Substrat 10 angeordnet.

Mittels des Temperatursensors 3 wird die Betriebstemperatur des Halbleiterbauelements derart überwacht, dass beim Unterschreiten eines vorgegebenen Sollwerts der Betriebstemperatur des Halbleiterbauelements das Halbleiterbauelement mittels des elektrischen Heizelements 3 geheizt wird. Überschreitet die Betriebstemperatur den vorgegebenen Sollwert, so wird die Heizleistung des Heizelements reduziert oder das Heizelement ausgeschaltet. Bevorzugt sind das Halbleiterbauelement und der Temperatursensor unmittelbar benachbart zueinander angeordnet, wodurch die Überwachung der Betriebstemperatur erleichtert wird.

Zur Überwachung der Betriebstemperatur kann diese, beispielsweise über die bekannte Temperaturabhängigkeit des Widerstandes des NTC-Thermistors, über den Temperatursensor ermittelt werden und mittels einer, gegebenenfalls auf dem Träger angeordneten, Regelungsschaltung, etwa einer Transistorschaltung, die bevorzugt die ermittelte Betriebstemperatur mit dem Sollwert vergleicht, geregelt werden.

Gegenüber einer Betriebstemperatur des Halbleiterbauelements, die über einen vorgegebenen Umgebungstemperaturbereich variiert, kann so der Schwankungsbereich der betriebstemperaturabhängigen Peakwellenlänge des Halbleiterbauelements reduziert werden, indem das Halbleiterbauelement über das elektrische Heizelement gezielt geheizt und temperaturstabilisiert wird.

Der Detektionsbereich des Detektorelements kann somit mit Vorteil schmalbandiger ausgeführt werden als ein Schwankungsintervall der Peakwellenlänge der Strahlung 12 über dem Umgebungstemperaturbereich. Der Schwankungsbereich der Peakwellenlänge des temperaturstabilisierten Halbleiterbauelements wird vorzugsweise durch den Detektionsbereich des Detektorelements vollständig überdeckt.

Dies resultiert in einem optimierten Verhältnis vom von der Strahlung 12 erzeugten Detektorsignal zu einem, etwa durch Umgebungslichteinflüsse hervorgerufenen, Untergrundrauschen.

Der Betriebstemperaturbereich des Halbleiterbauelements kann beispielsweise von einem vorgegebenen Umgebungstemperaturbereich mit Temperaturen von -40°C bis 85°C auf einen Betriebstemperaturbereich von 20°C bis 85°C stabilisiert werden. Aufgrund der Temperaturabhängigkeit der Peakwellenlänge wird in der Folge die Peakwellenlänge des Halbleiterbauelements stabilisiert.

Die Temperaturabhängigkeit der Peakwellenlänge kann, insbesondere bei einer kantenemittierenden Laserdiode zur Erzeugung infraroter Strahlung, etwa in einem Spektralbereich von 800 bis 1000 nm, 0,3 nm/K betragen. In einem Umgebungstemperaturfenster der Breite 125 K, etwa von -40°C bis 85°C, als Betriebstemperaturbereich des ungeheizten Halbleiterbauelements bedeutet dies eine erhebliche Schwankung der Peakwellenlänge in einem Intervall einer Breite von ungefähr 38 nm, wobei mit steigender Betriebstemperatur die Peakwellenlänge wächst. Wird die Betriebstemperatur mittels elektrischer Heizung auf ein gegenüber obigem Bereich schmäleres Temperaturfenster, wie eines der Breite von 65 K, etwa von 20°C bis 85°C, stabilisiert, so kann die Breite des Schwankungsbereichs der Peakwellenlänge, etwa auf eine Breite von ungefähr 20 nm für ein Betriebstemperaturfenster von 65 K Breite, reduziert werden. Auch mit einem durch entsprechende Filter geschmälerten Detektionsbereich einer Breite von ungefähr 20 nm kann somit die vom Halbleiterbauelement erzeugte Strahlung über das Detektorelement im Betrieb des Halbleiterbauelements über den Umgebungstemperaturbereich zuverlässig detektiert werden. Umgebungslichteinflüsse auf das Detektorsignal werden durch den schmalen Detektionsbereich mit Vorteil verringert.

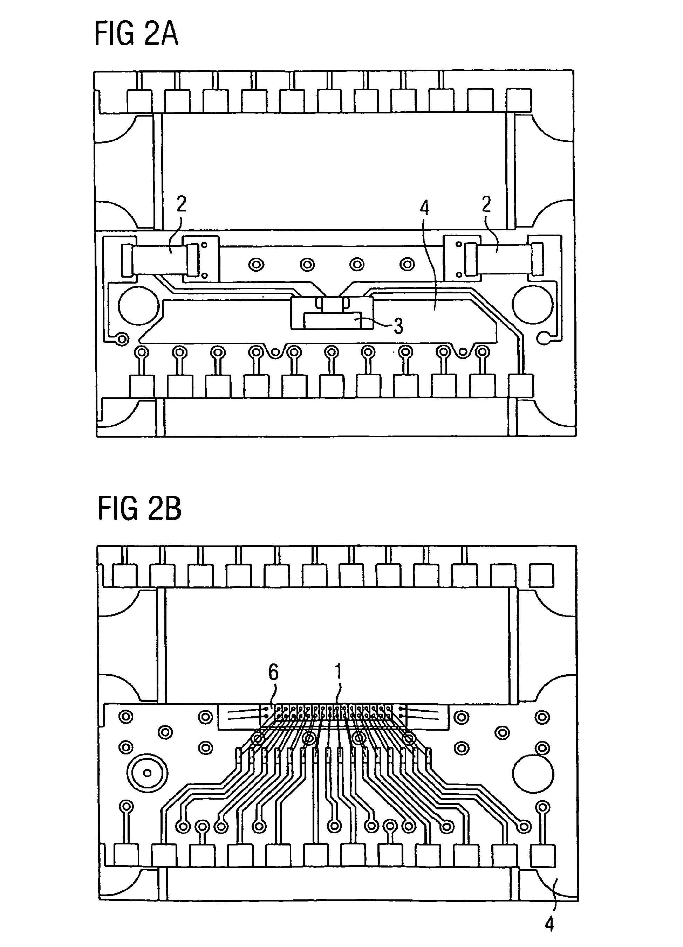

In Figur 2 ist anhand zweier schematischer Aufsichten in Figur 2A und 2B ein zweites Ausführungsbeispiel einer erfindungsgemäßen Vorrichtung dargestellt. Im Wesentlichen entspricht dieses Ausführungsbeispiel dem in Figur 1 gezeigten Ausführungsbeispiel. Im Unterschied hierzu sind zwei elektrische oberflächenmontierbare Heizwiderstände, beispielsweise jeweils mit einem Widerstand von 56 $\Omega$, etwa von der Bauform 1206 , vorgesehen, die ebenso wie der NTC-Thermistor als Temperatursensor 3, beispielsweise ein oberflächenmontierbarer 1k$\Omega$-NTC Widerstand mit einem Widerstand von 1k$\Omega$ bei Raumtemperatur (298K), auf der dem Halbleiterbauelement 1 gegenüberliegenden Seite des Trägers 4 angeordnet sind. Das Halbleiterbauelement ist hierbei als Laserdiodenarray (Laserdiodenbarren), insbesondere als Pulslaserdiodenarray, ausgeführt. Weitere Einzelheiten zu Laserdiodenbarren sind beispielsweise in dem Lehrbuch "Roland Diehl, High Power Diode Lasers, Springer (2000)", dessen Offenbarungsgehalt hiermit explizit durch Referenz in die vorliegende Anmeldung aufgenommen wird, genauer beschrieben (sh. insbesondere die dortigen Seiten 173 bis 218).

Das Array kann derart ausgebildet sein, dass die einzelnen Laserdiodenkanäle des Arrays getrennt voneinander ansteuerbar sind oder die einzelnen Kanäle nur gemeinsam betrieben werden können. Im letzteren Fall sind die Kanäle parallel geschalten und weisen hierzu einen allen Kanälen gemeinsamen Kontakt und einen allen Kanälen gemeinsamen Gegenkontakt auf. Für eine getrennte Ansteuerung der einzelnen Kanäle kann beispielsweise ein mit allen Kanälen leitend verbundener Gegenkontakt vorgesehen sein, wobei die einzelnen Kanäle jeweils einen separaten Einzelkontakt aufweisen, über den der Stromfluss durch den jeweiligen Kanal geregelt werden kann. Die einzelnen Kanäle sind dann über den jeweiligen Einzelkontakt unabhängig voneinander betreibbar.

Auf jedem der beispielsweise sechzehn Laserdiodenkanäle des Arrays sind hierbei zwei Bonddrähte zur elektrischen Kontaktierung zugeordnet. Der Gegenpol der Diodenkontaktierung wird mittels Bonddrähten, z.B. mit vier Bonddrähten, hergestellt, die beispielsweise über eine auf dem Zwischenträger 6, vorzugsweise zwischen dem Halbleiterbauelement und dem Zwischenträger, angeordneten, etwa metallhaltigen, Anschlussschicht, leitend mit dem Halbleiterbauelement und elektrischen Kontakten auf dem Träger 4, etwa Leiterbahnen eines PCB-Trägers, verbunden sind. Die Figuren 2A und 2B zeigen Aufsichten auf den Träger 4 von der Seite des Halbleiterbauelements 1 in Figur 2A und der diesem gegenüberliegenden Seite des Trägers 4 in Figur 1B.

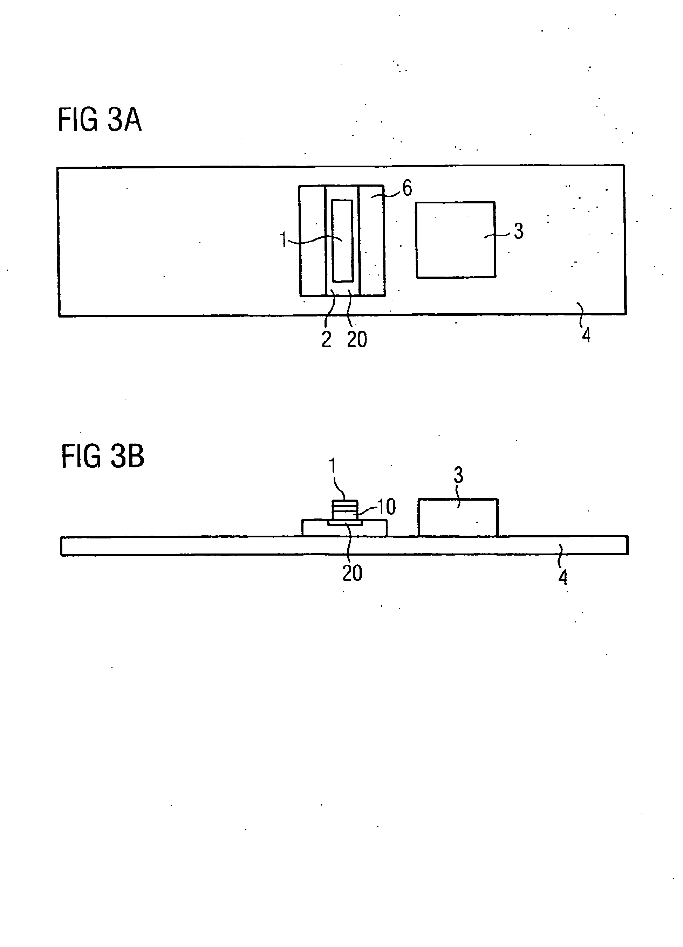

Figur 3 zeigt eine schematische Aufsicht auf ein drittes Ausführungsbeispiel einer erfindungsgemäßen Vorrichtung in Figur 3A und eine entsprechende schematische Schnittansicht in Figur 3B. Das Ausführungsbeispiel gemäß Figur 3 entspricht im Wesentlichen dem in Figur 1 gezeigten. Im Unterschied hierzu wurde auf ein diskretes elektrisches Heizelement verzichtet. Aus Übersichtlichkeitsgründen würde ferner auf eine Darstellung des Detektorelements und der thermischen Verbindungsleiter verzichtet, die jedoch selbstverständlich auch beim dritten Ausführungsbeispiel vorgesehen sein können.

Im Unterschied zum Ausführungsbeispiel gemäß Figur 1 ist das Halbleiterbauelement 1 in Figur 3 auf dem Heizelement 2 angeordnet. Insbesondere kann das Heizelement zwischen dem Träger und dem Halbleiterbauelement angeordnet sein. Das Heizelement 2 ist bevorzugt als Heizwiderstandsbereich 20 im Zwischenträger 6 integriert. Beispielsweise ist der Heizwiderstandsbereich 20 mittels Protonenimplantation in einem Bereich eines Si-Zwischenträgers hergestellt. Eine Anordnung des Heizwiderstandsbereichs 20, wie in Figur 3B dargestellt, direkt an der Oberfläche ist nicht zwingend erforderlich. Der Heizwiderstandsbereich kann vielmehr auch als vergrabener Bereich, insbesondere unterhalb der dem Zwischenträger zugewandten Oberfläche des Zwischenträgers, im Zwischenträger ausgebildet sein. Dementsprechend kann der Heizwiderstandsbereich 20 von dem Halbleiterbauelement 1 und/oder dem Substrat 10 beabstandet ist.

Bevorzugt weist der Heizwiderstandsbereich eine laterale Ausdehnung auf, die größer ist als die laterale Ausdehnung des Halbleiterbauelements, wodurch eine flächige und effiziente elektrische Beheizung des Halbleiterbauelements in verglichen mit diskreten Heizelemente unmittelbarer Nähe zum Halbleiterbauelement erleichtert wird.

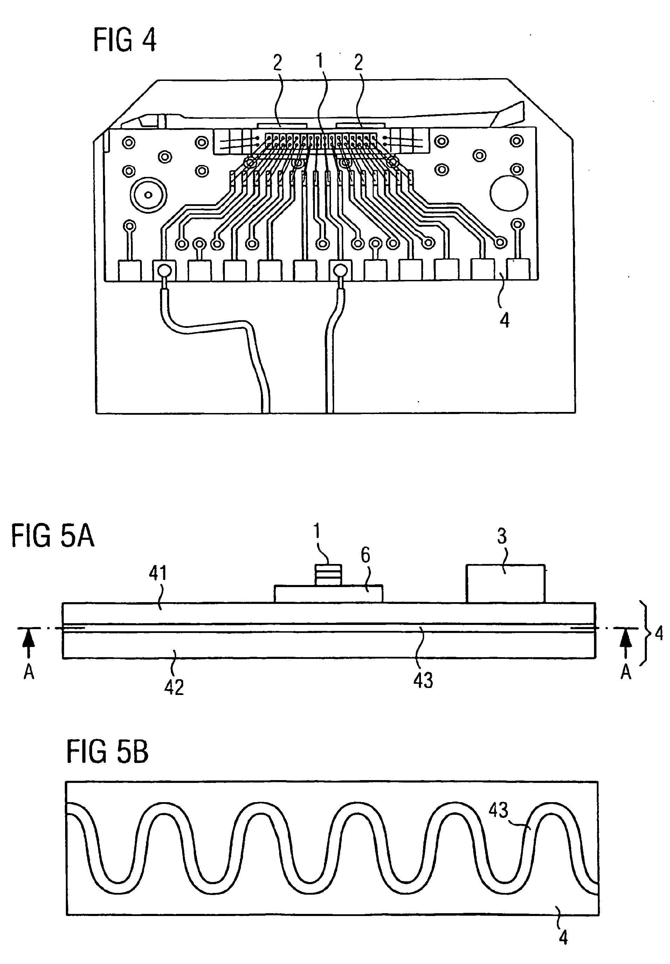

Figur 4 zeigt eine schematische Aufsicht auf ein viertes Ausführungsbeispiel einer erfindungsgemäßen Vorrichtung. Das Halbleiterbauelement 1 ist entsprechend Figur 2 als Pulslaserdioden-Array ausgeführt. Zwischen dem Träger 4 und dem Halbleiterbauelement 1 sind zwei elektrische Heizelemente 2, beispielsweise in der Form zweier oberflächenmontierbarer Heizwiderstände, die elektrisch vom Halbleiterbauelement isoliert sind, angeordnet. Der Temperatursensor ist wie in Figur 2 auf der dem Halbleiterbauelement gegenüberliegenden Seite des Trägers angeordnet. Eine derartige Anordnung des elektrischen Heizelements kann zur Simulation und für Effizienzversuche eines im Zwischenträger integrierten Heizelements, etwa gemäß Figur 3, herangezogen werden.

Figur 5 zeigt eine schematische Schnittansicht eines fünften Ausführungsbeispiels einer erfindungsgemäßen Vorrichtung in Figur 5A und eine entsprechende schematische Schnittaufsicht eines Schnitts entlang der Linie A-A in Figur 5B.

Im Wesentlichen entspricht das fünfte Ausführungsbeispiel dem dritten Ausführungsbeispiel aus Figur 3. Im Unterschied hierzu ist das elektrische Heizelement im Träger 4 integriert. Der Träger 4 weist hierbei eine Mehrschichtstruktur auf, die eine erste Schicht 41 auf der dem Halbleiterbauelement 1 zugewandten Seite und eine zweite Schicht 42 auf der dem Halbleiterbauelement abgewandten Seite aufweist, zwischen denen eine Heizwiderstandsschicht 43 angeordnet ist.

Die Heizwiderstandsschicht enthält beispielsweise Cu und/oder verläuft etwa, wie in Figur 5B gezeigt, als meanderförmige Bahn. Die Heizwiderstandsschicht 43 ist über die erste Schicht 41 und den Zwischenträger 6 thermisch leitend mit dem Halbleiterbauelement 1 verbunden. Bevorzugt ist die erste Schicht 41 und/oder die zweite Schicht 42 elektrisch isolierend ausgeführt. Die thermisch leitende Verbindung zum Zwischenträger oder dem Halbleiterbauelement kann insbesondere über das elektrisch isolierende Material der ersten Schicht 41 erfolgen.

Weiterhin kann gegebenenfalls zusätzlich oder alternativ ein thermischer Verbindungsleiter, der sich durch die erste Schicht 41 erstreckt und beispielsweise über den Zwischenträger 6 mit dem Halbleiterbauelement 1 und der Heizwiderstandsschicht, vorzugsweise direkt, thermisch leitend verbunden ist, vorgesehen sein.

Das elektrische Heizelement kann in dieser Ausführung mit Vorteil bereits integriert mit dem Träger 4 gefertigt werden. Auf eine zusätzliche Anordnung eines diskreten Heizelements oder eine Ausbildung des Zwischenträgers als Heizelement kann somit verzichtet werden.

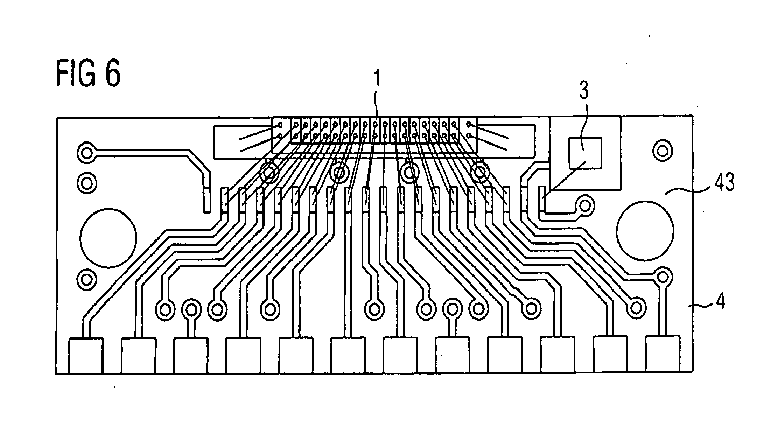

Figur 6 zeigt eine schematische Aufsicht auf ein sechstes Ausführungsbeispiel einer erfindungsgemäßen Vorrichtung, das im wesentlichen dem in Figur 4 gezeigten entspricht. Im Unterschied hierzu ist eine Heizwiderstandsschicht 43 entsprechend den Ausführungen zu Figur 5 im Träger 4 integriert und der Temperatursensor 3 und das Halbleiterbauelement 1 sind auf der gleichen Trägerseite, - angeordnet.

Die anhand der folgenden Figuren erläuterten Zusammenhänge wurden an einem Halbleiterlaser-Bauelement, etwa gemäß dem in Figur 2 gezeigten, ermittelt.

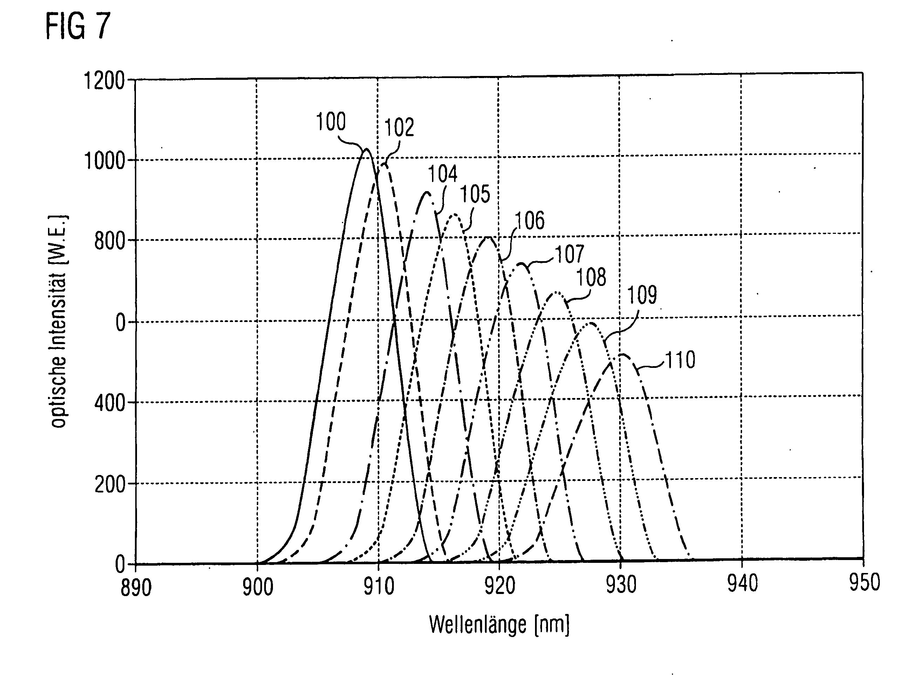

In Figur 7 ist die Temperaturabhängigkeit des Emissionsspektrums des Halbleiterlaser-Bauelements gezeigt. Hierbei wurde eine Mehrschichtstruktur mit einer meanderförmigen Heizwiderstandsbahn, etwa aus Cu, eines Widerstands von 65 Ω bei Raumtemperatur zur elektrischen Beheizung des Halbleiterlaser-Bauelements eingesetzt.

Aufgetragen ist in Figur 7 die optische Intensität der vom Halbleiterlaser-Bauelement erzeugten Strahlung in willkürlichen Einheiten und in Abhängigkeit von der Wellenlänge der vom Halbleiterlaser-Bauelement erzeugten Strahlung in nm. Das Halbleiterlaser-Bauelement ist insbesondere zur Erzeugung infraroter Strahlung, etwa einer Wellenlänge größer oder gleich 900 nm, ausgebildet. Zur Beheizung wurden an die Heizwiderstandsbahn-verschiedene Heizspannungen angelegt. Hierbei entsprechen folgende Heizspannungen folgenden Kurven der Emissionsverteilung des Bauelements:

| Heizspannung in V | Kurve |
| --- | --- |
| 0 | 100 |
| 2 | 102 |
| 4 | 104 |
| 5 | 105 |
| 6 | 106 |
| 7 | 107 |
| 8 | 108 |
| 9 | 109 |
| 10 | 110 |

Hierbei ist deutlich die Temperaturabhängigkeit der Peakwellenlänge - der Wellenlänge des Emissionsmaximums der jeweiligen Verteilung - zu erkennen, wobei größere Heizspannungen in der Regel höheren Temperaturen entsprechen und sich die Peakwellenlänge für steigende Spannungen zu höheren Wellenlängen verschiebt. Mit steigenden Spannungen verflacht die Emissionsverteilung.

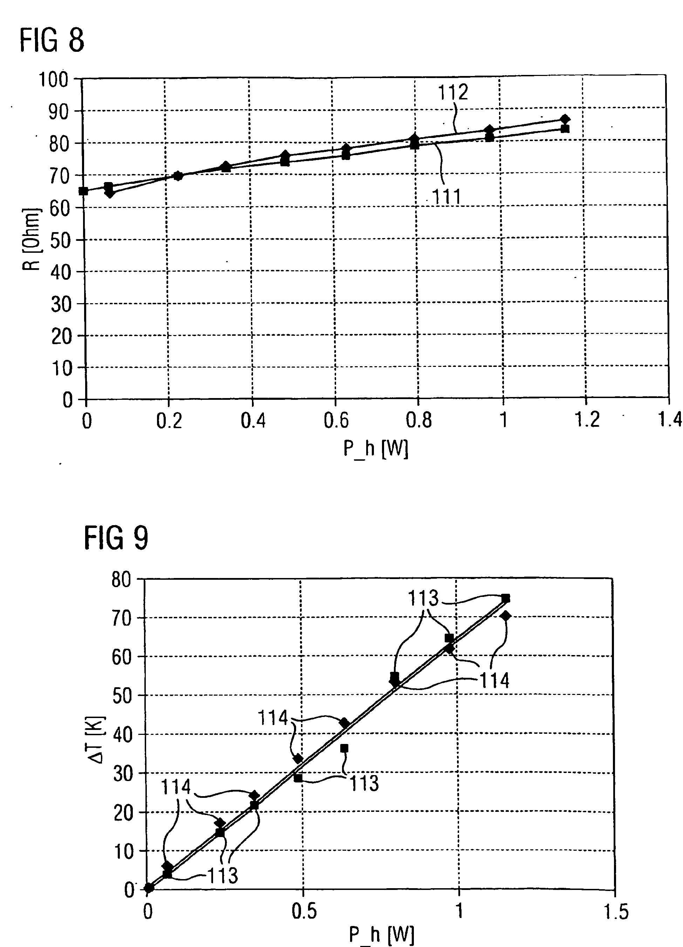

In Figur 8 ist die Temperaturabhängigkeit des Widerstands R einer Heizwiderstandsschicht aus Cu in einer Mehrschichtstruktur in Ohm in Abhängigkeit von der Heizleistung P_h in Watt dargestellt. Bei Raumtemperatur beträgt der Widerstand etwa 65 Ω Für die Kurve 111 wurde die Temperaturabhängigkeit des Widerstandes R von der Temperaturänderung ΔT - gegenüber der Raumtemperatur - über die Beziehung

$$R(T) = R_N \cdot (1 + \alpha \cdot \Delta T)$$

mit $\alpha = 0{,}004$ l/K und $R_N = 65\Omega$ bestimmt. Für die Kurve 112 wurde der Widerstand R aus der Heizspannung und dem gemessenen Heizstrom bestimmt. Die auf diese verschiedenen Weisen gewonnenen Verläufe des Widerstands stimmen in guter Näherung überein.

Bei einem oberflächenmontierbaren Heizwiderstand, etwa der oben genannten Art (vergleiche die Ausführungen zu Figur 2) mit $\alpha = 0{,}0001$ l/K, ist die Temperaturabhängigkeit des Widerstandes in der Regel vernachlässigbar gering.

Figur 9 zeigt einen Vergleich der Temperaturbestimmung der Betriebstemperatur des mit der Heizleistung P_h mittels einer im Träger integrierten Heizwiderstandsschicht beheizten Halbleiterlaser-Bauelements über die bekannte Temperaturabhängigkeit der Peakwellenlänge und über einen 1 kΩ NTC-Widerstand als Temperatursensor. Aufgetragen ist die Temperaturänderung ΔT gegenüber der Raumtemperatur $T_N$ in Abhängigkeit von der Heizleistung. Die Datenpunkte 113 der Betriebstemperatur wurden aus der Temperaturabhängigkeit der Peakwellenlänge bestimmt, die sich bei einem infrarot emittierenden Halbleiterlaser-Bauelement ungefähr um 0,30 nm pro K ändert. Bei dem 1 kΩ NTC-Widerstand wurde die Temperatur T des Temperatursensors über den gemessenen temperaturabhängigen Widerstand R(T), der mit T über die Beziehung

$$T = \left[ \frac{1}{B} \cdot \ln\left( \frac{R(T)}{\cdot R_N} \right) + \frac{1}{T_N} \right]$$

verknüpft ist, ermittelt. Hierbei sind: B= 3263 l/K, $R_N$= 1 kΩ und $T_N$= 298 K. Diese Ergebnisse sind durch die Datenpunkte 114 wiedergegeben.

Aus Figur 9 ist ersichtlich, dass die über die Peakwellenlänge ermittelte Temperatur des Halbleiterlaser-Bauelements mit der Temperatur des Temperatursensors im Wesentlichen übereinstimmt, so dass über den Temperatursensor die Betriebstemperatur des Halbleiterlaser-Bauelements zuverlässig ermittelt werden kann. Eine Fitgerade für einen linearen Zusammenhang zwischen den Datenpunkten 113 ergibt sich zu

$$y = 64.085 \cdot x$$

und eine für die Datenpunkte 114 zu

$$y = 64.114 \cdot x \qquad .$$

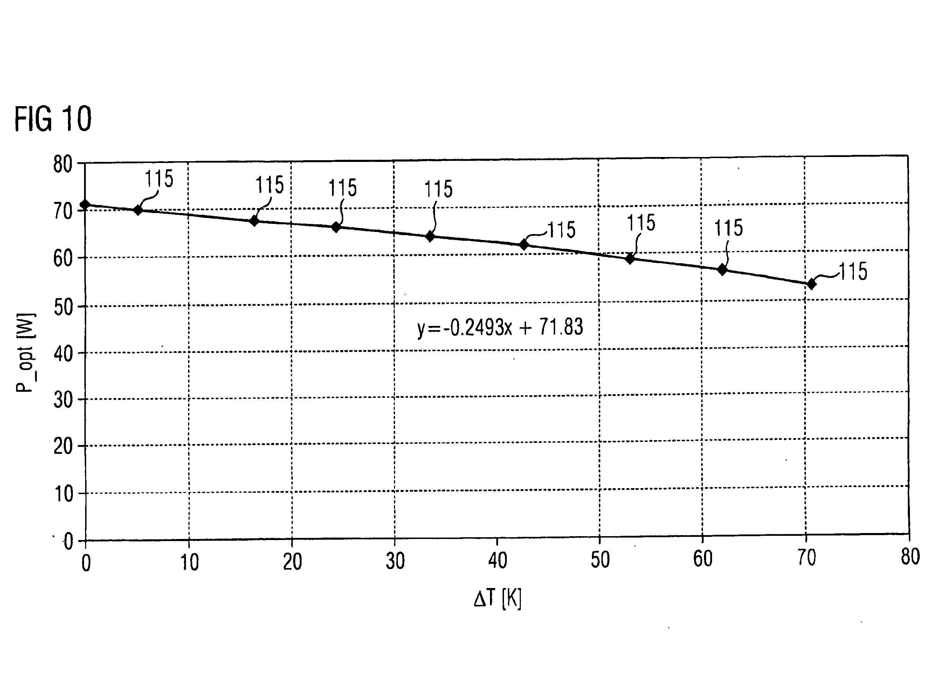

In Figur 10 ist die Abhängigkeit der optischen Peak-Leistung des Halbleiterlaser-Bauelements P_opt in Watt von der Änderung ΔT der Betriebstemperatur des Halbleiterlaser-Bauelements in Kelvin gegenüber der. Raumtemperatur gezeigt. Zu erkennen ist, dass die optische Peak-Leistung des Halbleiterlaser-Bauelements mit steigender Temperatur im Wesentlichen linear abnimmt. Eine Fitgerade für die den gemessenen Peak-Leistungen entsprechenden Datenpunkte 115 ergibt sich zu

$$y = -0.2493 \cdot x + 71.83 \quad .$$

Die Abnahme der optischen Peak-Leistung mit steigender Temperatur beträgt demnach ungefähr -0.25 W/K.

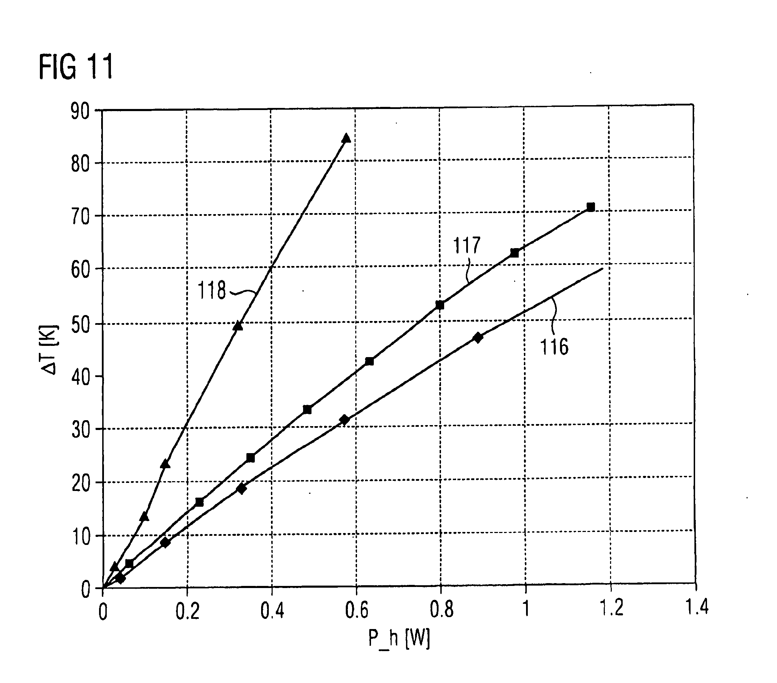

In Figur 11 ist ein Vergleich der Temperaturänderung ΔT des Halbleiterlaser-Bauelements in Kelvin in Abhängigkeit von der Heizleistung P_h in Watt für ein auf verschiedene Weisen beheiztes Halbleiterlaser-Bauelement gezeigt. Für die Kurve 116 wurde das Halbleiterlaser-Bauelement mittels zweier diskreter Heizwiderstände (gemäß Figur 2 mit jeweils 56 Ω), für die Kurve 117 mittels einer im Träger integrierten Heizwiderstandsschicht (gemäß Figur 6 mit einem Widerstand von 65 Ω bei Raumtemperatur) und für die Kurve 118 mittels zweier zwischen dem Halbleiterlaser-Bauelement und dem Träger angeordneter Heizwiderstände (gemäß Figur 4 mit jeweils 56 Ω) beheizt. Über letztere Variante wurde ein im Zwischenträger integrierter Heizwiderstandsbereich simuliert.

In Figur 11 ist zu erkennen, dass in der Kurve 118 vergleichsweise kleine Heizleistungen vergleichsweise hohe Temperaturänderungen hervorrufen (ungefähr: 85 K bei 0,58 W Heizleistung gegenüber 70 K bei 1,2 W in Kurve 117 und 60 K bei 1,2 W in Kurve 116). Eine Teilfitkurve ergibt sich für die Kurve 116 zu

$$y = -10.536 \cdot x^2 + 62.039 \cdot x \quad ,$$

für die Kurve 117 zu

$$y = -12.761 \cdot x^2 + 75.74 \cdot x$$

und für die Kurve 118 zu

$$y = -39.48 \cdot x^2 + 169.64 \cdot x \quad .$$

Ein im Zwischenträger integrierter Heizwiderstandsbereich ist für eine Beheizung des Halbleiterbauelements demnach besonders geeignet, jedoch auch mit vergleichsweise hohem Aufwand und Kosten verbunden.
Eine Beheizung über eine Heizwiderstandsschicht ist demgegenüber kostengünstiger, wobei diskrete Heizwiderstande besonders einfach handhabbar und kostengünstig sind. Insbesondere können SMD-Heizwiderstände mittels Oberflächenmontage besonders einfach in die Vorrichtung integriert werden.

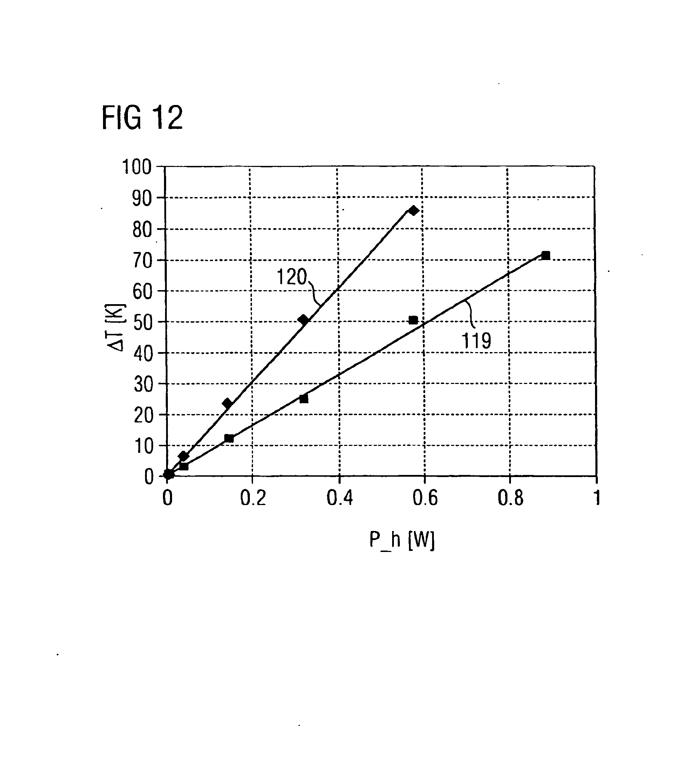

Figur 12 zeigt einen Vergleich der Temperaturbestimmung der Betriebstemperatur des mit der Heizleistung P_h mittels zweier zwischen Träger und Halbleiterlaser-Bauelement angeordneter Heizwiderstände beheizten Halbleiterlaser-Bauelements über die bekannte Temperaturabhängigkeit der Peakwellenlänge einerseits und über einen vom Halbleiterbauelement beabstandet angeordneten 1 kΩ NTC-Widerstand (siehe die Ausführungen zu Figur 9) als Temperatursensor andererseits. Aufgetragen ist jeweils die Temperaturänderung ΔT gegenüber der Raumtemperatur in Abhängigkeit von der Heizleistung. Die Kurve 119 der über den NTC-Widerstand bestimmten Temperaturänderung weicht erheblich von der Kurve 120, die über die Peakwellenlänge ermittelt wurde, ab. Die über die Peakwellenlänge ermittelte Temperaturänderung ist größer als die Temperaturänderung, die über den NTC-Widerstand ermittelt wurde. Die mittels der Peakwellenlänge ermittelte Temperatur entspricht etwa der Betriebstemperatur und die mittels des NTC-Widerstandes ermittelte Temperatur entspricht verstärkt der Umgebungstemperatur. Eine nah benachbarte Anordnung der Heizwiderstände zum Halbleiterlaser-Bauelement resultiert demnach in einer äußerst effizienten Beheizung. Eine Fitgerade für die Kurve 119 ergibt sich zu

$$y = 80.546 \cdot x$$

und für die Kurve 120 zu

$$y = 149.95 \cdot x \quad .$$

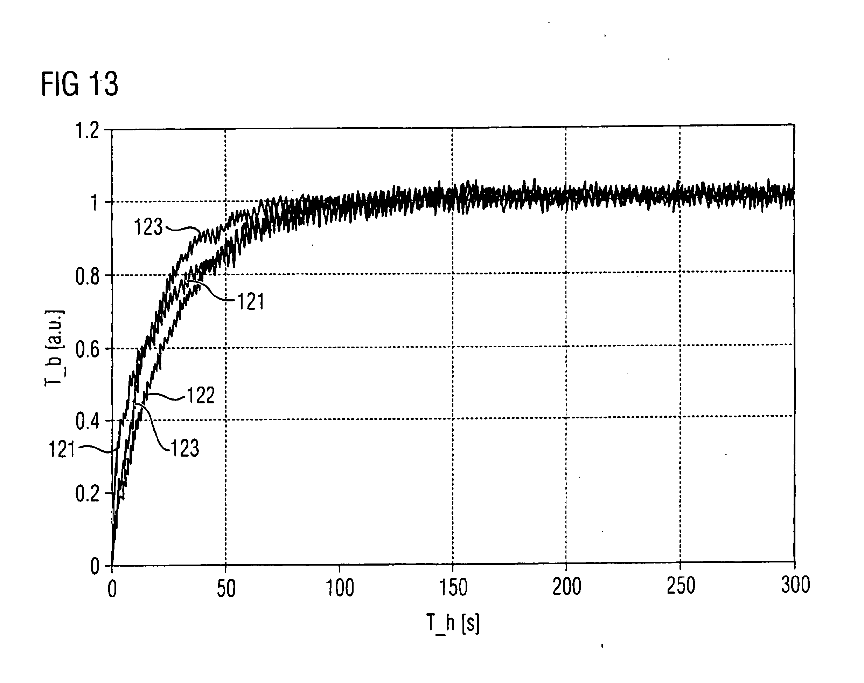

Figur 13 zeigt das thermische Einschwingverhalten des Halbleiterlaser-Bauelements für die obigen drei Beheizungsvarianten anhand der Abhängigkeit der auf 1 normierten Betriebstemperatur T_b des Halbleiterlaser-Bauelements in willkürlichen Einheiten von der Beheizungszeit T_h des Halbleiterlaser-Bauelements in Sekunden. Die Kurve 121 entspricht der Variante gemäß Figur 4 mit zwei Heizwiderständen, die zwischen dem Halbleiterlaser-Bauelement und dem Träger angeordnet sind, die Kurve 122 der Variante mit der im Träger integrierten Heizwiderstandsschicht gemäß Figur 6 und die Kurve 123 der Variante mit den zwei diskreten Heizwiderständen gemäß Figur 2. Die Betriebstemperatur erreicht für alle drei Varianten den maximalen Wert nach ungefähr 100 s, was dem Erreichen des thermischen Gleichgewichts zwischen dem Heizelement, der Umgebung und dem Halbleiterlaser-Bauelement entspricht.

Die thermische Zeitkonstante τ, nach der die Betriebstemperatur des Halbleiterlaser-Bauelements die Hälfte ihrer Maximaltemperatur beträgt, liegt für die drei Varianten zwischen, jeweils einschließlich, ungefähr 20 s und ungefähr 25 s.

Die vorliegende Patentanmeldung beansprucht die Priorität der deutschen Patentanmeldung DE 10 2004 009 588.4 vom 25. Februar 2004.

Die Erfindung ist nicht durch die Beschreibung anhand der Ausführungsbeispiele beschränkt. Vielmehr umfasst die Erfindung jede Kombination von Merkmalen gemäß den Patentansprüchen.

**Patentansprüche**

1. Vorrichtung mit mindestens einem strahlungsemittierenden Halbleiterbauelement (1), wobei
dem Halbleiterbauelement mindestens ein elektrisches Heizelement (2) zugeordnet ist, das zum Heizen des Halbleiterbauelements ausgebildet ist, wobei
das Halbleiterbauelement (1) zur Erzeugung von Strahlung (12) einer Peakwellenlänge ausgebildet ist, die über einen vorgegebenen Umgebungstemperaturbereich, in dem das Halbleiterbauelement zum Betrieb vorgesehen ist, in einem Schwankungsbereich variiert, und
dem Halbleiterbauelement (1) ein Detektorelement (13) zur Detektion der vom Halbleiterbauelement emittierten Strahlung (12) zugeordnet ist, **dadurch gekennzeichnet, dass** das Detektorelement zur Detektion von Strahlung mit Wellenlängen in einem vorgegebenen Detektionsbereich ausgebildet ist, der Schwankungsbereich der Peakwellenlänge des ungeheizten Halbleiterbauelements Wellenlängen außerhalb des Detektionsbereichs aufweist und der Detektionsbereich den Schwankungsbereich der Peakwellenlänge des geheizten Halbleiterbauelements überdeckt.

2. Vorrichtung nach Anspruch 1,
**dadurch gekennzeichnet, dass**
eine Breite des Schwankungsbereichs der Peakwellenlänge über Heizen des Halbleiterbauelements (1) mittels des Heizelements (2) von einer ersten Breite des ungeheizten Halbleiterbauelements auf eine zweite Breite des geheizten Halbleiterbauelements reduziert ist, wobei die zweite Breite kleiner als die erste Breite ist.

3. Vorrichtung nach einem der vorhergehenden Ansprüche,
**dadurch gekennzeichnet, dass**
dem Halbleiterbauelement (1) ein Temperatursensor (3) zur Überwachung der Betriebstemperatur des Halbleiterbauelements zugeordnet ist.

4. Vorrichtung nach Anspruch 3,
**dadurch gekennzeichnet, dass**
der Betrieb des Heizelements (2) mittels des Temperatursensors (3) steuerbar ist.

5. Vorrichtung nach Anspruch 3 oder 4,
**dadurch gekennzeichnet, dass**
der Temperatursensor (3) ein NTC-Element ist.

6. Vorrichtung nach einem der vorhergehenden Ansprüche,
**dadurch gekennzeichnet, dass**
das Halbleiterbauelement als Halbleiterlaser-Bauelement ausgeführt ist.

7. Vorrichtung nach Anspruch 6,
**dadurch gekennzeichnet, dass**
das Halbleiterlaser-Bauelement zum gepulsten Betrieb vorgesehen ist.

8. Vorrichtung nach einem der vorhergehenden Ansprüche,
**dadurch gekennzeichnet, dass**
das Halbleiterbauelement auf einem Träger (4) angeordnet ist.

9. Vorrichtung nach Anspruch 8,
**dadurch gekennzeichnet, dass**
der Träger (4) eine Leiterplatte ist.

10. Vorrichtung nach Anspruch 8 oder 9,
**dadurch gekennzeichnet, dass**
das Heizelement (2) auf dem Träger (4) angeordnet ist.

11. Vorrichtung nach einem der vorhergehenden Ansprüche,
**dadurch gekennzeichnet, dass**
das Heizelement (2) oberflächenmontierbar ausgebildet ist.

12. Vorrichtung nach einem der vorhergehenden Ansprüche,
**dadurch gekennzeichnet, dass**
das Heizelement (2) als Heizwiderstand ausgeführt ist.

13. Vorrichtung nach einem der Ansprüche 8 bis 12,
**dadurch gekennzeichnet, dass**
das Heizelement (2) im Träger (4) integriert ist.

14. Vorrichtung nach Anspruch 13,
**dadurch gekennzeichnet, dass**
der Träger eine Mehrschichtstruktur (41, 42, 43) aufweist und das Heizelement als Heizwiderstandsschicht (43) in der Mehrschichtstruktur integriert ist.

15. Vorrichtung nach einem der vorhergehenden Ansprüche,
**dadurch gekennzeichnet, dass**
das Heizelement (2) elektrisch von dem Halbleiterbauelement (1) isoliert ist.

16. Vorrichtung nach einem der vorhergehenden Ansprüche,
**dadurch gekennzeichnet, dass**
das Halbleiterbauelement (1) auf dem Heizelement (2) angeordnet ist.

**17.** Vorrichtung nach einem der Ansprüche 8 bis 16, **dadurch gekennzeichnet, dass** zwischen dem Träger (4) und dem Halbleiterbauelement (1) ein Zwischenträger (6) angeordnet ist.

**18.** Vorrichtung nach Anspruch 17, **dadurch gekennzeichnet, dass** der Zwischenträger (6) als Heizelement (2) ausgebildet ist oder das Heizelement enthält.

**19.** Vorrichtung nach Anspruch 17 oder 18, **dadurch gekennzeichnet, dass** das Heizelement ein Heizwiderstandsbereich (20) ist.

**20.** Vorrichtung nach Anspruch 19, **dadurch gekennzeichnet, dass** der Heizwiderstandsbereich (20) mittels Implantation im Zwischenträger (6) ausgebildet ist.

**21.** Vorrichtung nach einem der Ansprüche 17 bis 20, **dadurch gekennzeichnet, dass** der Zwischenträger (6) ein Halbleitermaterial enthält.

**22.** Vorrichtung nach einem der vorhergehenden Ansprüche, **dadurch gekennzeichnet, dass** das Halbleiterbauelement (1) zum Betrieb in einem Umgebungstemperaturbereich, der Temperaturen kleiner und größer 0°C umfasst, vorgesehen ist.

**23.** Vorrichtung nach Anspruch 22, **dadurch gekennzeichnet, dass** das Halbleiterbauelement (1) zum Betrieb in einem Umgebungstemperaturbereich von -40°C bis 85°C vorgesehen ist.

**24.** Vorrichtung nach Anspruch 22 oder 23, **dadurch gekennzeichnet, dass** die Betriebstemperatur des Halbleiterbauelements (1) bei Temperaturen im Bereich größer 0°C liegt.

**25.** Vorrichtung nach Anspruch 24, **dadurch gekennzeichnet, dass** die Betriebstemperatur des Halbleiterbauelements (1) bei Temperaturen im Bereich von 20°C bis 85°C liegt.

**26.** Verfahren zur Temperaturstabilisierung der Betriebstemperatur eines strahlungsemittierenden Halbleiterbauelements (1), wobei dem Halbleiterbauelement ein elektrisches Heizelement (2) zugeordnet ist, mittels dem das Halbleiterbauelement beim Unterschreiten eines vorgegebenen Sollwerts der Betriebstemperatur des Halbleiterbauelements geheizt wird, wobei das Halbleiterbauelement (1) zur Erzeugung von Strahlung (12) einer Peakwellenlänge ausgebildet ist, die über einen vorgegebenen Umgebungstemperaturbereich, in dem das Halbleiterbauelement zum Betrieb vorgesehen ist, in einem Schwankungsbereich variiert, und dem Halbleiterbauelement (1) ein Detektorelement (13) zur Detektion der vom Halbleiterbauelement emittierten Strahlung (12) zugeordnet ist, **dadurch gekennzeichnet, dass** das Detektorelement zur Detektion von Strahlung mit Wellenlängen in einem vorgegebenen Detektionsbereich ausgebildet ist, der Schwankungsbereich der Peakwellenlänge des ungeheizten Halbleiterbauelements Wellenlängen außerhalb des Detektionsbereichs aufweist und der Detektionsbereich den Schwankungsbereich der Peakwellenlänge des geheizten Halbleiterbauelements überdeckt.

**27.** Verfahren nach Anspruch 26, **dadurch gekennzeichnet, dass** beim Überschreiten des vorgegebenen Sollwerts der Betriebstemperatur des Halbleiterbauelements die Heizleistung des Heizelements reduziert oder das Heizelement ausgeschaltet wird.

**28.** Verfahren nach Anspruch 26 oder 27, **dadurch gekennzeichnet, dass** eine Breite des Schwankungsbereichs der Peakwellenlänge über Heizen des Halbleiterbauelements (1) mittels des Heizelements (2) von einer ersten Breite des ungeheizten Halbleiterbauelements auf eine zweite Breite des geheizten Halbleiterbauelements reduziert wird, wobei die zweite Breite kleiner als die erste Breite ist.

**29.** Verfahren nach einem der Ansprüche 26 bis 28, **dadurch gekennzeichnet, dass** die Betriebstemperatur des Halbleiterbauelements (1) mittels eines dem Halbleiterbauelement zugeordneten Temperatursensors (4) überwacht wird.

**30.** Verfahren nach Anspruch 29, **dadurch gekennzeichnet, dass** der Betrieb des Heizelements (2) mittels des Temperatursensors (4) gesteuert wird.

**31.** Verfahren nach einem der Ansprüche 26 bis 30, **dadurch gekennzeichnet, dass** eine Vorrichtung gemäß einem der Ansprüche 1 bis 25 das Halbleiterbauelement umfasst.

**Claims**

**1.** Device having at least one radiation-emitting semiconductor component (1), the semiconductor component being assigned at least one electrical heating element (2) designed for heating the semiconductor component, the semiconductor component (1) being designed for generating radiation (12) having a peak wavelength that varies in a fluctuation range over a predetermined ambient temperature range in which the semiconductor component is provided for operation, and the semiconductor component (1) being assigned a detector element (13) for detecting the radiation (12) emitted by the semiconductor component, **characterized in that** the detector element is designed for detecting radiation having wavelengths in a predetermined detection range, the fluctuation range of the peak wavelength of the unheated semiconductor component has wavelengths outside the detection range and the detection range covers the fluctuation range of the peak wavelength of the heated semiconductor component.

2. Device according to Claim 1,
 **characterized in that**
 a width of the fluctuation range of the peak wavelength is reduced, by the semiconductor component (1) being heated by means of the heating element (2), from a first width of the unheated semiconductor component to a second width of the heated semiconductor component, the second width being smaller than the first width.

3. Device according to one of the preceding claims,
 **characterized in that**
 the semiconductor component (1) is assigned a temperature sensor (3) for monitoring the operating temperature of the semiconductor component.

4. Device according to Claim 3,
 **characterized in that**
 the operation of the heating element (2) can be controlled by means of the temperature sensor (3).

5. Device according to Claim 3 or 4,
 **characterized in that**
 the temperature sensor (3) is an NTC element.

6. Device according to one of the preceding claims,
 **characterized in that**
 the semiconductor component is embodied as a semiconductor laser component.

7. Device according to Claim 6,
 **characterized in that**
 the semiconductor laser component is provided for pulsed operation.

8. Device according to one of the preceding claims,
 **characterized in that**
 the semiconductor component is arranged on a carrier (4).

9. Device according to Claim 8,
 **characterized in that**
 the carrier (4) is a printed circuit board.

10. Device according to Claim 8 or 9,
 **characterized in that**
 the heating element (2) is arranged on the carrier (4).

11. Device according to one of the preceding claims,
 **characterized in that**
 the heating element (2) is of surface-mountable design.

12. Device according to one of the preceding claims,
 **characterized in that**
 the heating element (2) is embodied as a heating resistor.

13. Device according to one of Claims 8 to 12,
 **characterized in that**
 the heating element (2) is integrated in the carrier (4).

14. Device according to Claim 13,
 **characterized in that**
 the carrier has a multilayer structure (41, 42, 43) and the heating element is integrated as heating resistance layer (43) in the multilayer structure.

15. Device according to one of the preceding claims,
 **characterized in that**
 the heating element (2) is electrically insulated from the semiconductor component (1).

16. Device according to one of the preceding claims,
 **characterized in that**
 the semiconductor component (1) is arranged on the heating element (2).

17. Device according to one of Claims 8 to 16,
 **characterized in that**
 a submount (6) is arranged between the carrier (4) and the semiconductor component (1).

18. Device according to Claim 17,
 **characterized in that**
 the submount (6) is designed as heating element (2) or contains the heating element.

19. Device according to Claim 17 or 18,
 **characterized in that**
 the heating element is a heating resistance region (20).

20. Device according to Claim 19,
 **characterized in that**
 the heating resistance region (20) is formed by means of implantation in the submount (6).

21. Device according to one of Claims 17 to 20, **char-**

**acterized in that**
the submount (6) contains a semiconductor material.

22. Device according to one of the preceding claims, **characterized in that**
the semiconductor component (1) is provided for operation in an ambient temperature range comprising temperatures less than and greater than 0°C.

23. Device according to Claim 22, **characterized in that**
the semiconductor component (1) is provided for operation in an ambient temperature range from -40°C to 85°C.

24. Device according to Claim 22 or 23, **characterized in that**
the operating temperature of the semiconductor component (1) is at temperatures in the range greater than 0°C.

25. Device according to Claim 24, **characterized in that**
the operating temperature of the semiconductor component (1) is at temperatures in the range of from 20°C to 85°C.

26. Method for temperature stabilization of the operating temperature of a radiation-emitting semiconductor component (1), the semiconductor component being assigned an electrical heating element (2), by means of which the semiconductor component is heated when the operating temperature of the semiconductor component falls below a predetermined desired value of said operating temperature, the semiconductor component (1) being designed for generating radiation (12) having a peak wavelength that varies in a fluctuation range over a predetermined ambient temperature range in which the semiconductor component is provided for operation, and the semiconductor component (1) being assigned a detector element (13) for detecting the radiation (12) emitted by the semiconductor component, **characterized in that** the detector element is designed for detecting radiation having wavelengths in a predetermined detection range, the fluctuation range of the peak wavelength of the unheated semiconductor component has wavelengths outside the detection range and the detection range covers the fluctuation range of the peak wavelength of the heated semiconductor component.

27. Method according to Claim 26, **characterized in that**
when the predetermined desired value of the operating temperature of the semiconductor component is exceeded, the heating power of the heating element is reduced or the heating element is switched off.

28. Method according to Claim 26 or 27, **characterized in that**
a width of the fluctuation range of the peak wavelength is reduced, by the semiconductor component (1) being heated by means of the heating element (2), from a first width of the unheated semiconductor component to a second width of the heated semiconductor component, the second width being smaller than the first width.

29. Method according to one of Claims 26 to 28, **characterized in that**
the operating temperature of the semiconductor component (1) is monitored by means of a temperature sensor (4) assigned to the semiconductor component.

30. Method according to Claim 29, **characterized in that**
the operation of the heating element (2) is controlled by means of the temperature sensor (4).

31. Method according to one of Claims 26 to 30, **characterized in that**
a device according to one of Claims 1 to 25 comprises the semiconductor component.


**Revendications**

1. Dispositif comprenant au moins un composant semiconducteur (1) émettant un rayonnement,
au moins un élément chauffant (2) électrique étant associé au composant semiconducteur, lequel est configuré pour chauffer le composant semiconducteur,
le composant semiconducteur (1) étant configuré pour générer un rayonnement (12) ayant une longueur d'onde de crête qui varie dans une plage de fluctuation sur une plage de températures ambiantes prédéfinie dans laquelle le composant semiconducteur est destiné à fonctionner, et
un élément détecteur (13) destiné à la détection du rayonnement (12) émis par le composant semiconducteur étant associé au composant semiconducteur (1), **caractérisé en ce que**
l'élément détecteur est configuré pour la détection de rayonnement ayant des longueurs d'onde dans une plage de détection prédéfinie, la plage de fluctuation de la longueur d'onde de crête du composant semiconducteur non chauffé présente des longueurs d'onde en-dehors de la plage de détection et la plage de détection recouvre la plage de fluctuation de la longueur d'onde de crête du composant semiconducteur chauffé.

**2.** Dispositif selon la revendication 1, **caractérisé en ce qu'**une largeur de la plage de fluctuation de la longueur d'onde de crête, par le chauffage du composant semiconducteur (1) au moyen de l'élément chauffant (2), est réduite d'une première largeur du composant semiconducteur non chauffé à une deuxième largeur du composant semiconducteur chauffé, la deuxième largeur étant plus petite que la première largeur.

**3.** Dispositif selon l'une des revendications précédentes, **caractérisé en ce qu'**une sonde de température (3) destinée à surveiller la température de fonctionnement du composant semiconducteur est associée au composant semiconducteur (1).

**4.** Dispositif selon la revendication 3, **caractérisé en ce que** le fonctionnement de l'élement chauffant (2) peut être commandé au moyen de la sonde de température (3).

**5.** Dispositif selon la revendication 3 ou 4, **caractérisé en ce que** la sonde de température (3) est un élément à CTN.

**6.** Dispositif selon l'une des revendications précédentes, **caractérisé en ce que** le composant semiconducteur est réalisé sous la forme d'un composant laser semiconducteur.

**7.** Dispositif selon la revendication 6, **caractérisé en ce que** le composant laser semiconducteur est conçu pour un fonctionnement pulsé.

**8.** Dispositif selon l'une des revendications précédentes, **caractérisé en ce que** le composant semiconducteur est disposé sur un support (4).

**9.** Dispositif selon la revendication 8, **caractérisé en ce que** le support (4) est un circuit imprimé.

**10.** Dispositif selon la revendication 8 ou 9, **caractérisé en ce que** l'élément chauffant (2) est disposé sur le support (4).

**11.** Dispositif selon l'une des revendications précédentes, **caractérisé en ce que** l'élément chauffant (2) est configuré pour être monté en surface.

**12.** Dispositif selon l'une des revendications précédentes, **caractérisé en ce que** l'élément chauffant (2) est réalisé sous la forme d'une résistance chauffante.

**13.** Dispositif selon l'une des revendications 8 à 12, **caractérisé en ce que** l'élément chauffant (2) est intégré dans le support (4).

**14.** Dispositif selon la revendication 13, **caractérisé en ce que** le support possède une structure multicouche (41, 42, 43) et l'élément chauffant est intégré dans la structure multicouche sous la forme d'une couche résistive chauffante (43).

**15.** Dispositif selon l'une des revendications précédentes, **caractérisé en ce que** l'élément chauffant (2) est isolé électriquement du composant semiconducteur (1).

**16.** Dispositif selon l'une des revendications précédentes, **caractérisé en ce que** le composant semiconducteur (1) est disposé sur l'élément chauffant (2).

**17.** Dispositif selon l'une des revendications 8 à 16, **caractérisé en ce qu'**une couche intermédiaire (6) est disposée entre le support (4) et le composant semiconducteur (1).

**18.** Dispositif selon la revendication 17, **caractérisé en ce que** la couche intermédiaire (6) est réalisée sous la forme d'un élément chauffant (2) ou contient l'élément chauffant.

**19.** Dispositif selon la revendication 17 ou 18, **caractérisé en ce que** l'élément chauffant est une zone résistive chauffante (20).

**20.** Dispositif selon la revendication 19, **caractérisé en ce que** la zone résistive chauffante (20) est formée par implantation dans la couche intermédiaire (6).

**21.** Dispositif selon l'une des revendications 17 à 20, **caractérisé en ce que** la couche intermédiaire (6) contient un matériau semiconducteur.

**22.** Dispositif selon l'une des revendications précédentes, **caractérisé en ce que** le composant semiconducteur (1) est conçu pour fonctionner dans une plage de températures ambiantes qui comprend des températures inférieures et supérieures à 0 °C.

**23.** Dispositif selon la revendication 22, **caractérisé en ce que** le composant semiconducteur (1) est conçu pour fonctionner dans une plage de températures ambiantes de - 40 °C à 85 °C.

**24.** Dispositif selon la revendication 22 ou 23, **caractérisé en ce que** la température de fonctionnement du composant semiconducteur (1) se trouve à des températures dans la plage supérieure à 0 °C.

**25.** Dispositif selon la revendication 24, **caractérisé en ce que** la température de fonctionnement du composant semiconducteur (1) se trouve à des températures dans la plage de 20 °C à 85 °C.

**26.** Procédé de stabilisation en température de la température de fonctionnement d'un composant semiconducteur (1) émettant un rayonnement, un élément chauffant (2) électrique étant associé au composant semiconducteur, au moyen duquel le composant semiconducteur est chauffé en cas de franchissement vers le bas d'une valeur de consigne prédéfinie de la température de fonctionnement du composant semiconducteur, le composant semiconducteur (1) étant configuré pour générer un rayonnement (12) ayant une longueur d'onde de crête qui varie dans une plage de fluctuation sur une plage de températures ambiantes prédéfinie dans laquelle le composant semiconducteur est destiné à fonctionner, et

un élément détecteur (13) destiné à la détection du rayonnement (12) émis par le composant semiconducteur étant associé au composant semiconducteur (1), **caractérisé en ce que**

l'élément détecteur est configuré pour la détection de rayonnement ayant des longueurs d'onde dans une plage de détection prédéfinie, la plage de fluctuation de la longueur d'onde de crête du composant semiconducteur non chauffé présente des longueurs d'onde en-dehors de la plage de détection et la plage de détection recouvre la plage de fluctuation de la longueur d'onde de crête du composant semiconducteur chauffé.

**27.** Procédé selon la revendication 26, **caractérisé en ce qu'**en cas de dépassement de la valeur de consigne prédéfinie de la température de fonctionnement du composant semiconducteur, la puissance de chauffage de l'élément chauffant est réduite ou l'élément chauffant est mis hors circuit.

**28.** Procédé selon la revendication 26 ou 27, **caractérisé en ce qu'**une largeur de la plage de fluctuation de la longueur d'onde de crête, par le chauffage du composant semiconducteur (1) au moyen de l'élément chauffant (2), est réduite d'une première largeur du composant semiconducteur non chauffé à une deuxième largeur du composant semiconducteur chauffé, la deuxième largeur étant plus petite que la première largeur.

**29.** Procédé selon l'une des revendications 26 à 28, **caractérisé en ce que** la température de fonctionnement du composant semiconducteur (1) est surveillée au moyen d'une sonde de température (4) associée au composant semiconducteur.

**30.** Procédé selon la revendication 29, **caractérisé en ce que** le fonctionnement de l'élément chauffant (2) est commandé au moyen de la sonde de température (4).

**31.** Procédé selon l'une des revendications 26 à 30, **ca-**ractérisé en ce qu'**un dispositif selon l'une des revendications 1 à 25 comprend le composant semiconducteur.

EP 1 605 560 B1

FIG 1A

13 □

12 ↑

FIG 1B

17

## FIG 2A

## FIG 2B

FIG 3A

FIG 3B

FIG 4

FIG 5A

FIG 5B

FIG 6

EP 1 605 560 B1

FIG 7

## FIG 8

## FIG 9

## FIG 10

$$y = -0.2493x + 71.83$$

EP 1 605 560 B1

FIG 11

EP 1 605 560 B1

FIG 12

FIG 13

EP 1 605 560 B1

**IN DER BESCHREIBUNG AUFGEFÜHRTE DOKUMENTE**

**In der Beschreibung aufgeführte Patentdokumente**

- DE 102004009588